Europäisches Patentamt

European Patent Office

Office européen des brevets

(11) Veröffentlichungsnummer: **0 215 374**
**A2**

## EUROPÄISCHE PATENTANMELDUNG

(21) Anmeldenummer: **86112158.0**

(51) Int. Cl.⁴: **H01S 3/08**

(22) Anmeldetag: **02.09.86**

(30) Priorität: **18.09.85 DE 3533296**

(43) Veröffentlichungstag der Anmeldung:
**25.03.87 Patentblatt 87/13**

(84) Benannte Vertragsstaaten:
**DE GB**

(71) Anmelder: **Siemens Aktiengesellschaft Berlin und München**
**Wittelsbacherplatz 2**
**D-8000 München 2(DE)**

(72) Erfinder: **Keil, Rudolf, Dr.**
**Pulverturmstrasse 24a**
**D-8000 München 45(DE)**

(54) **Dynamisch einmodiger Halbleiterlaser.**

(57) Es wird ein dynamisch einmodiger Halbleiterlaser beschrieben, der aus einer Laserdiode (1) mit angekoppeltem externem Resonator besteht. Der Resonator weist einen gegenüber einer Lichtaustrittsfläche (12) der Diode (1) angeordneten Resonatorspiegel (2) und eine zwischen der Diode (1) und dem Resonatorspiegel angeordnete Kollimationsoptik auf. Ein bekannter derartiger Laser läßt sich mit der gewünschten Resonatorlänge oftmals nicht oder nur sehr schwer herstellen. Es soll daher ein derartiger Laser angegeben werden, der relativ einfach und mit der gewünschten Resonatorlänge herstellbar ist. Dies wird erreicht, wenn die Kollimationsoptik aus einer brechenden hemisphärischen und mit ihrer Flachseite (31) auf den Resonatorspiegel (2) aufgebrachten Mikrolinse (3) besteht. Diese Linse kann einfach durch Aufschmelzen eines kleinen Glastropfens auf den Resonatorspiegel hergestellt werden.

FIG 1

EP 0 215 374 A2

# Dynamisch einmodiger Halbleiterlaser

Die vorliegende Erfindung betrifft einen dynamisch einmodigen Halbleiterlaser nach dem Oberbegriff des Patentanspruchs 1.

In der optischen Breitbandübertragung werden Halbleiterlaser benötigt, die ein Spektrum mit nur einem longitudinalen Mode aufweist. Derzeit erhältliche Dioden sind zwar in vielen Fällen im cw-Betrieb, d.h. bei Gleichlicht einmodig, bei Ankopplung einer Glasfaser oder bei Modulation werden diese Laserdioden jedoch multimodig.

Dynamisch einmodige Halbleiterlaser, d.h. Halbleiterlaser, die auch bei Ankopplung einer Faser und bei Modulation einmodig und damit dynamisch einmodig bleiben, können beispielsweise mit DFB-Lasern (siehe Utaka K., Akiba S, Sakai K. und Matsushima Y.:

Room-temperature CW operation of distributed-feedback buried-heterostructure InGaAsP/InP lasers emitting at 1.57 $\mu$m, Electron. Lett. 17 (1981) S. 961-963), DBR-Lasern (siehe Abe Y., Kishino K., Tanbun-Ek T., Arai S., Koyama F., Matsumoto K., Watanabe T. und Suematsu Y.: Room-temperature CW operation of 1.60 $\mu$m GaInAsP/InP buried-heterostructure integrated laser with butt-jointed built-in distributed-Bragg-reflection waveguide, Electron. Lett. 18 (1982) S. 410-411), C$^3$ -Lasern (siehe Tsang W.T., Wolsson N.A., Linke R.A., Logan R.A.: 1.5 $\mu$m wavelength GaInAsP-C$^3$-lasers single-frequency operation and wideband frequency tuning, Electron. Lett. 19 (1983) S. 415-417) oder mit gekoppelten Laserarrays (siehe Kappeler F., Westermeier H., Gessner R., Druminski M., Zschauer K.H.: High cw power arrays of optically coupled -(Ga,Al)As oxide stripe lasers with dc-to-light conversion efficiencies of up to 36 %, 9th IEEE Int. Semicond. Laser Conf., Aug. 1984, Rio de Janeiro) aufgebaut werden. Alle diese Möglichkeiten sind jedoch technologisch sehr schwierig, beispielsweise beim DBR-Laser oder DFB-Laser, oder von den Aufbau-Toleranzen und der notwendigen Stabilität her sehr kritisch, wie beispielsweise beim C$^3$-Laser. Bei Laserarrays müssen mehrere Laser parallel betrieben werden, um einen DSM-Laser zu erreichen. Dies erfordert einen hohen Leistungsbedarf und die Wärmeabfuhr wird kritisch.

Eine weitere Möglichkeit zur Erzielung dynamisch einmodiger Halbleiterlaser ist die Ankopplung eines externen Resonators an eine einmodige Laserdiode, beispielsweise an eine konventionelle BH-Laserdiode. Eine Ausführungsform eines derartigen dynamisch einmodigen Halbleiterlasers ist aus Liou U.Y., Granlund S.W. , Swan C.B.: Single-longitudinalmode operation of GRIN external coupled-cavitiy semiconductor lasers, Opt. Fiber Comm., Jan. 1984, New Orleans, bekannt und entspricht dem dynamisch einmodigen Halbleiterlaser der eingangs genannten Art. Bei dieser Ausführung besteht die Kollimatoroptik aus einer Linse aus einem Stück Gradientenfaser mit 1/4 pitch Länge. Die der Lichtaustrittsfläche der Laserdiode zugekehrte Stirnfläche ist entspiegelt, so daß die verspiegelte entgegengesetzte Stirnfläche zusammen mit dem Laserspiegel den externen Resonator bildet. Die Resonatorlänge ist durch die Faserparameter, beispielsweise numerische Apertur und Faserradius, festgelegt und läßt sich durch Variation der Faserlänge nur begrenzt verhindern. Die zum Teil notwendigen sehr kurzen Resonatoren, deren Länge beispielsweise zwischen 100 $\mu$m und 200 $\mu$m liegen kann, können mit den normalerweise erreichbaren Faserparametern nicht oder nur sehr schwer hergestellt werden.

Aus Voumard C., Salathe R. und Weber I.: Single-mode operation of diode lasers coupled to hemispherival resonators, Opt. Commun. 13 (1975) S. 130-132 ist ein dynamisch einmodiger Halbleiterlaser in Form einer Laserdiode mit angekoppeltem externen Resonator bekannt, der als sphärischer Hohlspiegel mit einem Spiegelradius von 50 $\mu$m bis 200 $\mu$m ausgebildet ist. Die Herstellung derart kleiner Spiegelradien mit genügender Qualität und Genauigkeit erscheint sehr schwierig.

Aufgabe der vorliegenden Erfindung ist es, einen dynamisch einmodigen Halbleiterlaser anzugeben, der relativ einfach und mit der gewünschten Resonatorlänge herstellbar ist.

Diese Aufgabe wird mit einem Halbleiterlaser der eingangs genannten Art dadurch gelöst, daß gemäß dem kennzeichnenden Teil des Patentanspruchs 1 die Kollimationsoptik aus einer brechenden hemispärischen und mit ihrer Flachseite auf dem Resonatorspiegel aufgebrachten Mikrolinse besteht.

Vorteile dieser Lösung bestehen in der Variatinsmöglichkeit der Resonatorlänge im gewünschten Bereich, in einer einfachen und gut reproduzierbaren Herstellung und in der Tatsache, daß keine Verspiegelungs-oder Mehrfachentspiegelungsschichten nötig sind.

Letzteres findet seinen Grund darin, daß die Reflexion von der der Lichtaustrittsfläche der Laserdiode zugekehrten gewölbten Oberfläche der Mikrolinse durch deren starke Krümmung relativ - schlecht an den Lasermode angepaßt ist, so daß davon nur eine geringe Störung zu erwarten ist. Im Bedarfsfall kann diese geringe Störung durch eine Einfachentspiegelung der gewölbten Oberfläche der Linse (Anspruch 2) stark reduziert werden.

Bei einer bevorzugten Ausführungsform der erfindungsgemäßen Laserdiode besteht gemäß Anspruch 3 der Resonatorspiegel aus einem .flach gedrückten Draht.

Bevorzugterweise besteht die Mikrolinse gemäß Anspruch 4 aus einem hochbrechenden Schwerflintglas.

Im Hinblick auf die Herstellung der Linse durch Aufschmelzen ist es von Vorteil, wenn gemäß Anspruch 5 der Resonatorspiegel und die Mikrolinse aus Materialien bestehen, deren Temperaturausdehnungskoeffizienten im wesentlich übereinstimmen. Dadurch wird eine gute Haftung der Glaslinse auf dem Linsenträger erreicht.

In diesem Fall ist es überdies von Vorteil, wenn gemäß Anspruch 6 der Resonatorspiegel aus Platin-Rodium und die Linse aus einem Lanthan-Schwerflintglas besteht. Der Vorteil von Lanthan-Schwerflintglas ist neben dem hohen Brechungsindex die niedrige Schmelztemperatur von 550-600°C. Der Temperaturausdehnungskoeffizient dieses Glases beträgt $86.10^{-7}K^{-1}$ und stimmt gut mit dem Temperaturausdehnungskoeffizienten von Platin-Rodium (Pt.Rh) überein, der $92,7.10^{-7}K^{-1}$ beträgt. Dadurch wird eine gute Haftung der Glaslinse auf dem Linsenträger erreicht. Außerdem hat es sich gezeigt, daß die Spiegeleigenschaften des Resonatorspiegels aus Platium-Rodium durch das Aufschmelzen des Glases bei etwa 600°C nicht verschlechtert werden.

Bei einem vorteilhaften Verfahren zur Herstellung eines Resonatorspiegels mit einer aufgebrachten brechenden hemisphärischen Mikrolinse, insbesondere für einen erfindungsgemäßen Halbleiterlaser, wird gemäß Anspruch 7 so vorgegangen, daß auf den Resonatorspiegel ein kleiner Glastropfen aufgeschmolzen wird. Der Glastropfen formt sich durch die Oberflächenspannung nahezu halbkugelförmig.

Zum Aufschmelzen des Glastropfens wird dieser zweckmäßigerweise gemäß Anspruch 8 über eine beheizte Drahtspitze aufgenommen und auf den Resonatorspiegel aufgebracht. Die Glasmenge und damit der Linsenradius lassen sich gut über die Form und die eingestellte Temperatur der Drahtspitze kontrollieren.

Die Erfindung wird anhand der Figuren in der folgenden Beschreibung näher erläutert. Von den Figuren zeigen:

Figur 1 in schematischer Darstellung einen dynamisch einmodigen Halbleiterlaser in Form einer Laserdiode mit angekoppeltem externem Resonator, der einen Resonatorspiegel und eine darauf aufgebrachte brechende hemisphärische Mikrolinse aufweist;

Figuren 2 und 3 Emissionsspektren einer CSP-Laserdiode mit angekoppelter Faser bzw. mit angekoppelter Faser und externem Resonator entsprechend dem Aufbau nach Figur 1.

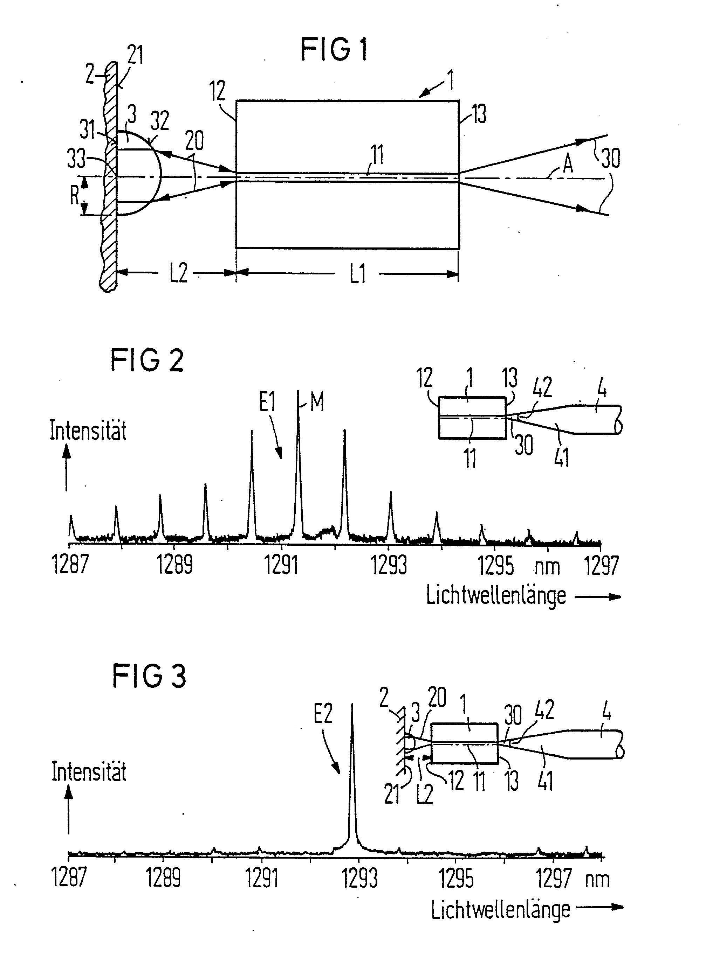

In der Figur 1 ist die einmodige, d.h. bei Gleichlicht einmodige, Laserdiode mit 1 und ihre optische Achse mit A bezeichnet, längs der sich die lichtemittierende laseraktive Zone 11 der Diode 1 erstreckt. Die Lichtaustrittsflächen 12 und 13 der Diode 1, aus denen im Bereich der Zone 11 das Laserlicht in Form divergenter Strahlen 20 und 30 in beiden Richtungen der optischen Achse A austritt, sind im wesentlichen senkrecht zu dieser Achse A angeordnet. Sie bestimmen die Länge $L_1$ der Diode 1.

Gegenüber der einen Lichtaustrittsfläche 12 ist in einem Abstand $L_2$ von der Diode 1 der Resonatorspiegel 2 angeordnet, dessen Spiegelfläche 21 der einen Lichtaustrittsfläche 12 zugekehrt und im wesentlichen senkrecht zur optischen Achse A der Diode 1 angeordnet ist. Auf der Spiegelfläche 21 ist eine brechende hemisphärische Mikrolinse 3 mit ihrer Flachseite 31 aufgebracht, so daß ihre konvex gewölbte Oberfläche 32 der einen Lichtaustrittsfläche 12 der Diode 1 zugekehrt ist. Die Mikrolinse 3 ist zweckmäßigerweise so angeordnet, daß· der Krümmungsmittelpunkt 33 der gewölbten Oberfläche 32 zumindest annähernd auf der optischen Achse A liegt.

Bisherige theoretische und experimentelle Untersuchungen zeigen, daß die besten Ergebnisse bezüglich der Seitenmodenunterdrückung bei einem Verhältnis $L_1/L_2$ von 3 -5 erreicht werden (siehe genannte Literaturstelle in Opt. Fiber Commun., Jan. 1984). Die optische Länge $L_2$ des externenn Resonators ist gegeben durch

$$L_2 = n_L \cdot R_L + \frac{R_L(1 - n_L/2)}{n_L - 1} + \sqrt{\left[\frac{n_L \cdot R_L}{2(n_L - 1)}\right]^2 - \left[\frac{\pi \cdot w_L^2}{\lambda_0}\right]^2}$$

Hierbei ist $R_L$ der im wesentlichen dem Krümmungsradius der konvex gewölbten Linsenfläche 32 entsprechende Linsenradius, $n_L$ der Brechungsindex der Linse und $\lambda_0$ die Vakuumwellenlänge des Lichts. $w_L$ ist die mittlere Fleckweite des Laserstrahls 20 in der Lichtaustrittsfläche 12. Diese mittlere Fleckweite ist definiert durch

$$\sqrt{w_{\parallel} \cdot w_{\perp}} \, ,$$

wobei $w_{\parallel}$ und $w_{\perp}$ zwei senkrecht zueinander gemessene Durchmesser des Laserflecks bedeuten.

Nimmt man bei dem Halbleiterlaser nach Figur 1 beispielsweise an, daß die Mikrolinse 3 aus hochbrechen dem Schwerflintglas mit $n_L$ = 1,82 und als Diode eine langwellige InGaAs-Laserdiode mit $\lambda_0$ = 1,3 $\mu$m, mit $w_L$ etwa 1 $\mu$m und mit $L_1$ = 200 $\mu$m verwendet sind, so ist für ein Verhältnis $L_1/L_2$ von 3 -5 ein Linsenradius RL von 40 -60 $\mu$m erforderlich.

Bei der Herstellung eines derartigen Halbleiterlasers wird als Resonatorspiegel 2 ein flachgedrückter PlatinRodium-Draht verwendet, auf den ein kleiner Tropfen aus beispielsweise dem Lanthan-Schwerflintglas LaSF9 aufgeschmolzen wird. Der Glastropfen formt sich durch die Oberflächenspannung nahezu halbkugelförmig. Er wird über eine beheizte Platin-Rodium-Drahtspitze aufgenommen und auf den Linsenträger aufgebracht. Die Glasmenge und damit der Linsenradius lassen sich gut über die Form und die eingestellte Temperatur der Drahtspitze kontrollieren.

Danach wurde mit einer einmodigen 1,3 $\mu$m-CSP-Laserdiode ein dynamisch einmodiger Halbleiterlaser aufgebaut und sein Spektrum bei einer angekoppelten Monomodefaser mit Taper und angeschmolzener Linse gemessen. Zum Vergleich wurde auch das Spektrum der Laserdiode mit optimal angekoppeltem Fasertaper der Monomodefaser allein gemessen.

Die Figur 2 zeigt das Emissionsspektrum dieser Laserdiode bei angekoppelter Monomodefaser und zugleich ist in dieser Figur rechts die zugehörige Konfiguration aus der CSP-Laserdiode 1 mit der angekoppelten Monomodefaser 4 entsprechend einer Darstellung nach Figur 1 skizziert. Der aus der anderen Lichtaustrittsfläche 13 austretende Laserstrahl 30 der Laserdiode 1 wird über die angeschmolzene Linse 42 des Tapers 41 der Monomodefaser 4 in diese Faser eingekoppelt. Bei dieser Konfiguration wird das dargestellte Emissionsspektrum $E_1$ erhalten, das neben einem zentralen Mode M in Form einer Spitze zahlreiche Seitenmoden zeigt, die deutlich als relativ niedrigere Spitzen zu erkennen sind.

Die Figur 3 zeigt das Emissionsspektrum $E_2$ des mit der Konfiguration nach Figur 2 gebildeten dynamisch einmodigen Halbleiterlasers, dessen Konfiguration in der Figur 3 ebenfalls dargestellt ist. Er ist aus der Konfiguration nach Figur 2 durch die Ankopplung des externen Resonators mit dem Resonatorspiegel 2 und der brechenden hemisphärischen Mikrolinse 3 hervorgegangen. Der Linsenradius $R_L$ betrug 54 $\mu$m und $L_2$ etwa 100-150 $\mu$m. Wie das zugehörige Emissionsspektrum $E_2$ zeigt, erhält man ein nahezu einmodiges Spektrum.

## Ansprüche

1. Dynamisch einmodiger Halbleiterlaser, bestehend aus einer Laserdiode (1) mit angekoppeltem externem Resonator, der einen gegenüber einer Lichtaustrittsfläche (12) der Diode (1) angeordneten Resonatorspiegel (2) und eine zwischen der Diode (1) und dem Resonatorspiegel (2) angeordnete Kollimationsoptik aufweist, **dadurch gekennzeichnet**, daß die Kollimationsoptik aus einer brechenden hemisphärischen und mit ihrer Flachseite (31) auf den Resonatorspiegel (2) aufgebrachten Mikrolinse (3) besteht.

2. Laser nach Anspruch 1, **dadurch gekennzeichnet**, daß die der einen Lichtaustrittsfläche (12) der Diode (1) zugekehrte gewölbte Oberfläche (32) der Mikrolinse einfach entspiegelt ist.

3. Laser nach einem der vorhergehenden Ansprüche, **dadurch gekennzeichnet**, daß der Resonatorspiegel (2) aus einem flachgedrückten Draht besteht.

4. Laser nach einem der vorhergehenden Ansprüche, **dadurch gekennzeichnet**, daß die Mikrolinse (3) aus einem hochbrechenden Schwerflintglas besteht.

5. Laser nach einem der vorhergehenden Ansprüche, **dadurch gekennzeichnet**, daß der Resonatorspiegel (2) und die Mikrolinse (3) aus Materialien bestehen, deren Temperaturausdehnungskoeffizienten im wesentlichen übereinstimmen.

6. Laser nach Anspruch 6, **dadurch gekennzeichnet**, daß der Resonatorspiegel (2) aus Platin-Rodium und die Mikrolinse (3) aus einem Lanthan-Schwerflintglas besteht.

7. Verfahren zur Herstellung eines Spiegels mit einer aufgebrachten brechenden hemisphärischen Linse, insbesondere für den Resonator eines Lasers nach einem der vorhergehenden Ansprüche, **dadurch gekennzeichnet**, daß auf den Spiegel ein kleiner Glastropfen aufgeschmolzen wird.

8. Verfahren nach Anspruch 7, **dadurch gekennzeichnet**, daß zum Aufschmelzen des Glastropfens dieser über eine beheizte Drahtspitze aufgenommen und auf den Resonatorspiegel aufgebracht wird.

# FIG 1

# FIG 2

**Intensität**

E1    M

1287    1289    1291    1293    1295    nm    1297

Lichtwellenlänge ➝

# FIG 3

**Intensität**

E2

1287    1289    1291    1293    1295    1297    nm

Lichtwellenlänge ➝